# EUROPEAN PATENT APPLICATION

(11) **EP 4 239 356 A1**
(43) Date of publication of application: **06.09.2023**
(21) Application number: 22159499.7
(22) Date of filing: 01.03.2022
(51) Int. Cl.: G01R 33/54, G01R 33/48

(54) **PLANNING SUPPORT FOR MR EXAMINATIONS AFTER PREVIOUS X-RAY OR CT EXAMINATIONS**

(71) Applicant: Koninklijke Philips N.V., 5656 AG Eindhoven (NL)
(72) Inventor: LENGA, Matthias, Eindhoven (NL); BUERGER, Christian, Eindhoven (NL); VON BERG, Jens, Eindhoven (NL); LORENZ, Cristian, Eindhoven (NL)
(74) Representative: Philips Intellectual Property & Standards

(57) **Abstract**

The invention relates to a method for establishing an examination protocol (32) for executing an MR image acquisition (28) from a body (10) of a patient after a previous X-ray- and/or CT-based examination (21) of the same patient. It is an object of the invention to facilitate the planning of the subsequent MR examination (28) matching the clinical question on which the prior X-ray or CT-based examination (21) is based. The method of the invention comprises the following steps: reading an input dataset (31) representing examination results of the previous X-ray- and/or CT-based examination (21) into a computer (15); in said computer (15), executing an algorithm processing said input dataset (31) to automatically derive one or more parameters of the examination protocol (32) for executing the subsequent MR image acquisition (28); and making an output dataset available representing said examination protocol (32) as a proposal to a user and/or executing the subsequent MR image acquisition (28) on an MR scanner (1) based on said examination protocol (32). Moreover, the invention relates to an MR scanner (1), to a computer (15) and to a computer program for an MR scanner (1).

## Description

### FIELD OF THE INVENTION

The present invention relates to the field of magnetic resonance (MR). It finds particular application in conjunction with MR imaging methods and MR scanners for diagnostic purposes, and will be described with particular reference thereto.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

The safe and accurate diagnosis of potentially seriously affected patients is sometimes complex and often involves multiple steps. Radiologic imaging plays a central role in the evaluation of these patients. Typical clinical workflows involve X-ray or CT examinations at an early stage as X-ray and CT scanners are fast, highly available and easy to operate. Based on such initial examination results, clinicians frequently decide to have a subsequent MR examination conducted in order to reduce the risk of overlooking a disease or injury. These subsequent MR examinations not only detect injuries missed by plain X-ray radiography or CT imaging, but also enable a more precise identification and delineation of injuries that were already visible in the X-ray or CT images.

In practice, the subsequent MR examination (as any MR examination) requires careful manual planning of the exact location, orientation, required coverage, resolution and contrast for the MR images that will be used for diagnosis. This planning procedure is complicated and requires a well-trained and experienced expert. Depending on the availability of such qualified operators, a significant delay between the time point of the first X-ray or CT acquisition and the execution of the subsequent MR examination may occur. Such latencies are clearly undesirable and may negatively impact the clinical workflow. Moreover, in case no trained expert is available, subsequent MR examinations may have to be postponed putting the patient's well-being at risk and reducing the occupancy rate of available MR scanners.

Pekar, V. et al. (Planning of Scan Geometries in Spine MRI Scans", in: Ayache, N., Ourselin, S., Maeder, A. (eds.) MICCAI 2007, Part I. LNCS, vol. 4791, pp. 601-608. Springer, Heidelberg, 2007) have proposed a method for automated planning of MR imaging scans of the spine. The automated scan planning system consists of an anatomy recognition part, which is able to automatically detect and label the spine anatomy in a scout scan, and a planning part, which performs scan geometry planning based on recognized anatomical landmarks.

### SUMMARY OF THE INVENTION

From the foregoing it is readily appreciated that there is a need for an improved method of planning MR examinations after previous X-ray or CT acquisitions. It is consequently an object of the invention to facilitate the planning of a subsequent MR examination matching the clinical question on which the prior X-ray or CT image acquisition was based.

In accordance with the invention, a method for establishing an examination protocol for executing an MR image acquisition from a body of a patient after a previous X-ray- and/or CT-based examination of the same patient is disclosed. The method comprises the following steps:
- reading an input dataset representing examination results of the previous X-ray-and/or CT-based examination into a computer;
- in said computer, executing an algorithm processing said input dataset to automatically derive one or more parameters of the examination protocol for executing the subsequent MR image acquisition; and
- making an output dataset available representing said examination protocol as a proposal to a user and/or executing the subsequent MR image acquisition on an MR scanner based on said examination protocol.

The proposed method includes automatic processing of the initial X-ray or CT-based examination results in order to propose a suitable MR examination protocol. In all situations, irrespective of availability of skilled operators, the proposed approach will lead to workflow improvements by using CT or X-ray based results directly and automatically to define the required MR examination protocol.

In order to use the MR scanner for the subsequent MR acquisition, the MR scanner and components incorporated in the MR scanner are controlled with a number of parameters that are available for selection. A set of such parameters constitutes an examination protocol in the context of the invention. The parameters selected depend on the examination object (the patient) and on the clinical question. The parameters can determine, e.g., a specific MR pulse sequence or physical variables, such as a voltage to be applied to a component, for example a radio-frequency antenna of the MR scanner. A parameter can also be a duration between two radio-frequency pulses and/or magnetic field gradients to be activated. By stipulating a resolution, for example, the parameters can characterize the MR image to be acquired. Further parameters can determine the location, orientation and size of the field of view as well as the contrast-weighting (e.g. T₁-weighting, T₂-weighting, diffusion-weighting etc.) of the subsequent MR image acquisition.

According to the invention, the computer reads the previously stored examination results of the X-ray- and/or CT-based examination. The key component of the proposed system is the algorithm, i.e. a software module for automated planning of the subsequent MR acquisition by processing the data representing the examination results of the previous X-ray and/or CT examination. The software module determines one or more parameters or completely generates an examination protocol proposal (e.g. represented as a so-called "ExamCard").

In an embodiment of the invention, a user, e.g. an operator of the MR scanner used is preferably notified of the result of the automatic planning, for example by a graphical representation of the generated output data set on a display monitor of the MR scanner. The notification typically takes the form of a suggestion to the user. A final determination regarding which examination protocol will be executed is made by the user, in particular a member of medical operating personnel supervising the MR examination. The user may apply modifications to the proposed examination protocol based on his individual knowledge and experience before he initiates the actual MR image acquisition.

In an alternative embodiment, the MR examination is initiated automatically based on the automatically determined examination protocol, i.e. without further involvement of a user who reviews and/or modified the parameters of the examination protocol.

Preferably, the input dataset is read from a database in which the examination results of the previous X-ray- and/or CT-based examination of the object are stored. The input dataset may include the corresponding X-ray and/or CT image data in digital representation. The input dataset may further include meta data of the X-ray- and or CT-based examination, i.e. parameters and device settings applied during the acquisition of the X-ray or CT images. Moreover, the input data may comprise medical findings data related to the X-ray- and or CT-based examination of the patient (e.g. in the form of a digital structured report having a standardized format). The input data may further comprise medical history data of the patient including, e.g., the indication/clinical question of the current examination, vital sign data of the patient (pulse, blood pressure, blood oxygenation, respiratory rate, body temperature etc.), biometric data of the patient (height, age, gender, weight etc.), as well as an indication of the body region of interest. The input data may yet further comprise segmentation masks (i.e. the results of an organ segmentation based on the X-ray or CT images) and/or parameters indicating the image quality of the prior X-ray- and or CT-based examination.

In a possible embodiment, the processing of the input data involves an automated image analysis including, e.g., an automatic organ segmentation, a localization of anatomical landmarks, and/or a determination of a field of view of the X-ray- or CT-based examination. Organ segmentation can be used for anatomy recognition, which enables automatic detection of the anatomy in the prior X-ray or CT images. The geometry of the subsequent MR acquisition (location and/or orientation of the field of view) can then be planned automatically by the algorithm based on recognized anatomical landmarks.

The algorithm processing the input dataset according to the invention may rely on an internal rule-based system, a statistical model, a machine learning method and/or a neural network to derive said one or more parameters from said input data set. Preferably, a machine learning algorithm (which may employ a neural network, such as, e.g., a so-called Deep Learning algorithm known as such in the art) is used, in which knowledge is generated from experience. The machine learning algorithm enables identification of patterns and relationships in examples contained in learning data. The machine learning algorithm learns from these examples and generalizes these after a learning phase is complete. In the learning phase the algorithm can identify, e.g. using available data on previous manual MR acquisition plannings performed by an operator based on associated prior X-ray or CT image data, typical determinations of certain examination parameters, and/or a pattern in the parameter determination in association with properties and features of the prior X-ray or CT image data (and, if applicable, additional related data as mentioned above). The derivation of the parameters of the examination protocol by the machine learning algorithm can then be made automatically on the basis of such patterns.

The method of the invention described thus far can be carried out by means of a computer used in a clinical workflow. The computer may be a control computer of an MR scanner including at least one main magnet coil for generating a main magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, with the control computer controlling the temporal succession of RF pulses and switched magnetic field gradients based on an examination protocol, and a reconstruction unit for reconstructing MR images from the received MR signals. The method of the invention is preferably implemented by a corresponding programming/software of the control computer of the MR scanner.

The method of the invention can be advantageously carried out in most MR environments in clinical use at present. To this end it is merely necessary to utilize a computer program by which the computer to be used is controlled such that it performs the above-explained method steps of the invention. The computer program may be present either on a data carrier or be present in a data network so as to be downloaded for installation in the computer, e.g. the control computer of an MR scanner.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR scanner for carrying out the method of the invention;
Fig. 2 illustrates the general principal of the method of the invention as a block diagram;
Fig. 3 illustrates an application of the method of the invention for MR imaging of the spine.

### DETAILED DESCRIPTION OF EMBODIMENTS

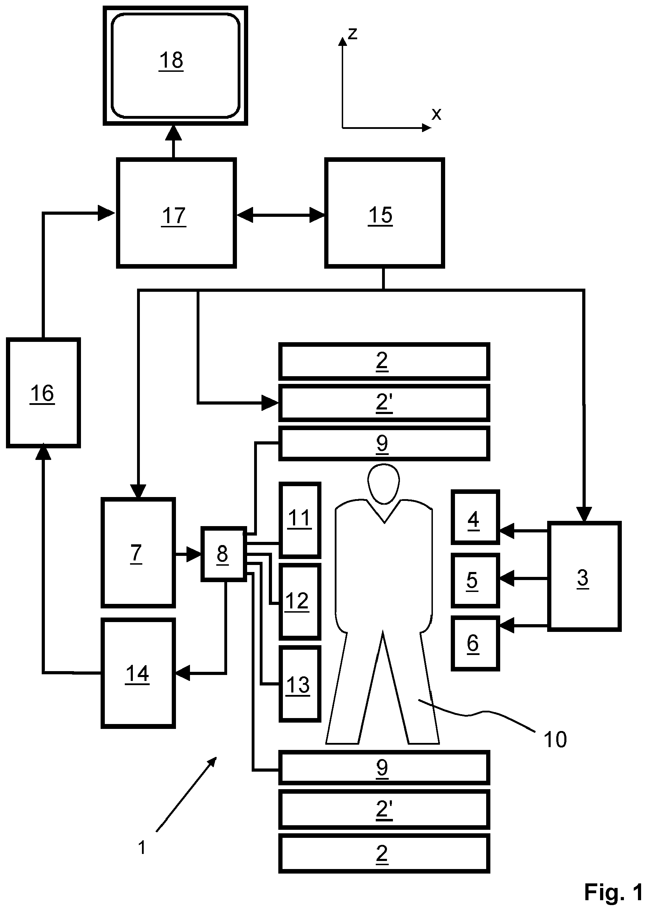

With reference to Fig 1, an MR scanner 1 is shown. The scanner comprises superconducting or resistive main magnet coils 2 such that a substantially uniform, temporally constant main magnetic field B₀ is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

Most specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR pulse sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions. The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A control computer 15 controls the current flow through the shimming coils 2' as well as the gradient pulse amplifier 3 and the transmitter 7 to generate any of a plurality of MR pulse sequences, such as echo planar imaging (EPI), echo volume imaging, gradient and spin echo imaging, fast spin echo imaging, and the like in conformity with a pre-determined examination protocol. For the respective examination protocol, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR scanners the data acquisition system 16 is a separate computer which is specialized in acquisition of raw image data. The examination protocol comprises a set of parameters. These parameters determine the MR pulse sequence including the frequency and the temporal succession of radio-frequency pulses and/or magnetic field gradients to be activated. The parameters thereby characterize the MR image to be acquired, in particular with regard to location, orientation and size of the field of view as well as the contrast-weighting.

Ultimately, the digital raw image data is reconstructed into an image representation by a reconstruction processor 17 which applies a Fourier transform or other appropriate reconstruction algorithms, such like SENSE or SMASH. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

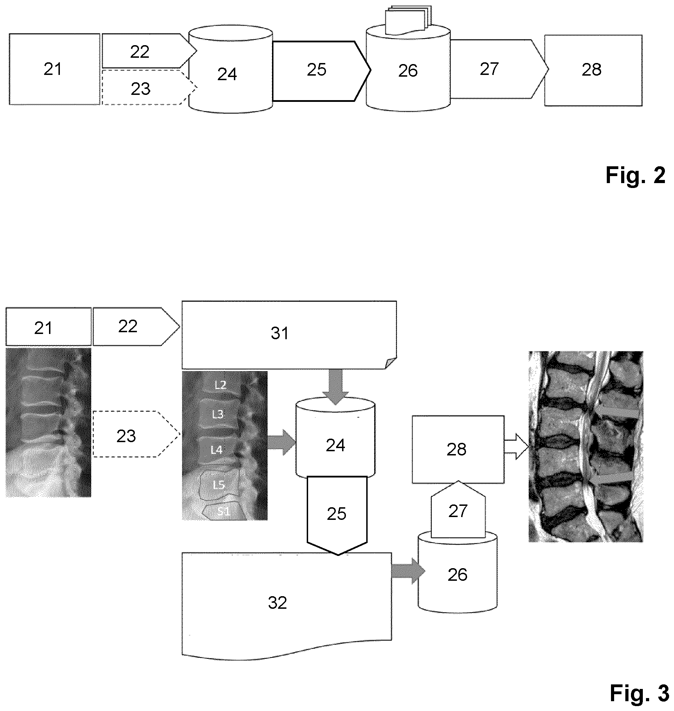

In the schematic overview of the method of the invention shown in Fig. 2, an initial X-ray or CT examination is performed in step 21. The X-ray or CT image data is analysed manually by a radiologist in step 22. Optionally, the X-ray or CT image data may undergo an automated image analysis (e.g. based on a neural network for pathology detection) in step 23. Digital representation of the X-ray or CT images together with the associated medical findings and diagnostic indications (e.g. as a structured report) are stored in a database 24. Additional relevant information (e.g. organ segmentation masks, bounding boxes indicating the region of interest) can also be derived and stored to the database 24. At this stage, aggregated data from the initial X-ray or CT examination (image data, diagnostic reports, biometric measurement data, segmentation masks, image quality figs., etc.) and possibly other personal health information of the patient are available in the database 24. According to the invention, the control computer 15 reads the data from the database 24 as an input dataset and an algorithm implemented on the computer 15 processes the input data in step 25 to derive one or more parameters of an examination protocol for executing a subsequent MR image acquisition. To this end, the algorithm relies on an internal rule-based system, a statistical model, a machine learning method or a neural network which accepts the aggregated data of the prior X-ray or CT examination as input and returns one or more examination parameters or, preferably, a complete (possibly encoded) examination protocol. The thus determined examination protocol constitutes an output dataset of the algorithm which is stored (e.g. represented as an "ExamCard") in a priority queue (or simply a database) 26. For the subsequent MR image acquisition, the related examination protocol is reviewed by a radiologist in step 27. The radiologist can modify the examination parameter settings proposed by the algorithm and finally triggers the MR image acquisition which is then executed in step 28 based on the (modified) examination protocol.

As an example of practical relevance, the application of the proposed approach of the invention for a clinical use case related to MR spine analysis is illustrated schematically in Fig. 3. Fig. 3 uses the same reference numbers as in Fig. 2 for the same method steps.

A patient complaining about back pain in the lumbar spine region is examined. A first X-ray image of the spine is acquired in step 21 which is evaluated by a radiologist in step 22 and provides first indication of a congenital narrowing of the spinal canal. In step 23 an automated segmentation of the X-ray image resulting in segmentation masks of vertebrae L2, L3, L4, L5, S1 is performed. An initial structured report 31 comprising the X-ray image along with the additional automatically generated information (vertebrae segmentation masks, fracture detection results, scoliosis detection results, etc.), the medical history ("patient complains about back pain in the lumbar region") and the diagnostic findings ("X-ray provides indication of congenital narrowing of the spinal canal") is stored to the database 24. The database 24 is then queried and the computer algorithm of the invention processes the combined (multimodal) information from the structured report 31 related to the current patient in step 25. The algorithm generates an MR examination protocol proposal 32 based on the aggregated information in the structured report 31, wherein the examination protocol proposal 32 indicates in the depicted example: acquisition of sagittal Ti-weighted and T₂-weighted images, acquisition of transverse T₂-weighted images at L1-S1 levels, exclusion of a saturation band on the anterior side of a rectangular field of view, frequency-encoding in the anterior-posterior direction, phase-encoding in the feet-head direction. The automatically generated protocol 32 is stored as an "ExamCard" in the priority queue 26 and is then displayed to a radiologist in step 27 who can access the results of the prior X-ray examination and, if required, manually adjust the proposed parameter settings before finally triggering the subsequent MR image acquisition which is performed in step 28. The resulting MR image 33 confirms narrowing of the spinal canal at two positions (indicated by arrows).

## Claims

1. Method for establishing an examination protocol (32) for executing an MR image acquisition (28) from a body (10) of a patient after a previous X-ray- and/or CT-based examination (21) of the same patient, the method comprising the following steps:
- reading an input dataset (31) representing examination results of the previous X-ray- and/or CT-based examination (21) into a computer (15);
- in said computer (15), executing an algorithm processing said input dataset (31) to automatically derive one or more parameters of the examination protocol (32) for executing the subsequent MR image acquisition (28); and
- making an output dataset available representing said examination protocol (32) as a proposal to a user and/or executing the subsequent MR image acquisition (28) on an MR scanner (1) based on said examination protocol (32).

2. Method of claim 1, wherein said input dataset (31) is read from a database (24) in which the examination results of the previous X-ray- and/or CT-based examination (21) of the patient are stored.

3. Method of claim 1 or 2, wherein said input dataset (31) includes at least one of: X-ray and/or CT image data, meta data of the X-ray- and or CT-based examination, medical findings data related to the X-ray- and or CT-based examination of the patient, medical history data of the patient, vital sign data of the patient, biometric data of the patient, segmentation masks, and parameters indicating the image quality of the X-ray- and or CT-based examination (21).

4. Method of any one of claim 1-3, wherein the processing of said input data (31) involves an automated image analysis including at least one of: organ segmentation, localization of anatomical landmarks, and determination of a field of view of the X-ray- or CT-based examination.

5. Method of any one of claims 1-4, wherein said algorithm relies on an internal rule-based system, a statistical model, a machine learning method and/or a neural network to derive said one or more parameters from said input data set (31).

6. Method of any one of claims 1-5, wherein said one or more parameters determine at least one of: the type of an MR pulse sequence, location, orientation and size of a field of view, contrast-weighting, and resolution of the subsequent MR image acquisition (28).

7. Computer, configured to:
- read an input dataset (31) including examination results of an X-ray- and/or CT-based examination (21);
- execute an algorithm processing said input dataset (31) to automatically derive one or more parameters of an examination protocol (32) for executing an MR image acquisition (28); and
- make an output dataset available representing said examination protocol (32) to a user and/or execute the MR image acquisition (28) on an MR scanner (1) based on said examination protocol (32).

8. Computer program comprising instructions for:
- reading an input dataset (31) including examination results of an X-ray- and/or CT-based examination (21);
- executing an algorithm processing said input dataset (31) to automatically derive one or more parameters of an examination protocol (32) for executing an MR image acquisition (28); and
- making an output dataset available representing said examination protocol (32) to a user and/or executing the MR image acquisition (28) on an MR scanner (1) based on said examination protocol (32).

9. MR scanner comprising at least one main magnet coil (2) for generating a main magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from a body (10) of a patient positioned in the examination volume, a control computer (15) for controlling a temporal succession of RF pulses and switched magnetic field gradients based on an examination protocol (32), and a reconstruction unit (17) for reconstructing MR images (33) from the received MR signals, wherein the MR scanner (1) is arranged to perform the following steps:
- reading an input dataset (31) representing examination results of an X-ray-and/or CT-based examination (21) of said patient into said control computer (15);
- in said control computer (15), executing an algorithm processing said input dataset (31) to automatically derive one or more parameters of the examination protocol (32); and
- making an output dataset available representing said examination protocol (32) as a proposal to a user of the MR scanner (1) and/or executing the MR image acquisition (28) on the MR scanner (1) based on said examination protocol (32).
